# EUROPÄISCHE PATENTSCHRIFT

(11) **EP 2 130 210 B1**
(45) Veröffentlichungstag und Bekanntmachung des Hinweises auf die Patenterteilung: **28.09.2016**
(21) Anmeldenummer: 08708592.4
(22) Anmeldetag: 01.02.2008
(51) Int. Cl.: H01H 37/76

(54) **THERMOSICHERUNG**
THERMAL FUSE
FUSIBLE THERMIQUE

(30) Priorität: 26.03.2007 DE 102007014338
(43) Veröffentlichungstag der Anmeldung: 09.12.2009
(73) Patentinhaber: Robert Bosch GmbH, 70442 Stuttgart (DE)
(72) Erfinder: KNAB, Norbert, 77767 Appenweier (DE); SCHULZE-ICKING-KONERT, Georg, 77830 Buehlertal (DE); MOHR, Thomas, 77830 Buehlertal (DE); KOTTHAUS, Stefan, 76547 Sinzheim (DE); HABERL, Nikolas, 76547 Sinzheim (DE); STAMPFER, Stefan, 74321 Bietigheim-Bissingen (DE); MUELLER, Michael, 71277 Rutesheim (DE)
(86) Internationale Anmeldenummer: PCT/EP2008/051286
(87) Internationale Veröffentlichungsnummer: WO 2008/116685

(56) Entgegenhaltungen:
- EP-A- 0 715 483
- EP-A- 0 786 790
- DE-A1- 1 588 425
- DE-A1- 19 615 643
- US-A- 2 762 889
- US-A- 3 354 282

## Beschreibung

Die Erfindung betrifft eine Thermosicherung zum Unterbrechen eines Stromflusses in Modulen, insbesondere für den Einsatz im Automotiv-Bereich.

Um elektrische Module gegen Überhitzung zu schützen, werden irreversible Thermosicherungen benötigt, die bei einer zu hohen Umgebungstemperatur einen Strom führenden Leiter unterbrechen (auslösen). Die Thermosicherungen sind dabei so ausgelegt, dass die Auslösetemperatur nicht aufgrund eines hohen Stromflusses erreicht wird, so dass gewährleistet ist, dass diese nicht durch einen hohen Strom, sondern ausschließlich durch eine zu hohe Umgebungstemperatur ausgelöst werden können. Eine Thermosicherung dient also dazu, einen unabhängigen Abschaltpfad für elektrische Module zur Verfügung zu stellen, die bei unzulässig hohen Temperaturen in dem Modul, z.B. aufgrund von Ausfällen von Bauelementen, Kurzschlüssen, z.B. durch Fremdeinwirkung, Fehlfunktionen von Isolationswerkstoffen und dgl. den Stromfluss sicher unterbricht.

Herkömmliche Thermosicherungen basieren zumeist auf dem Konzept einer fixierten Feder, wie z.B. einer angelöteten Blattfeder, die im Auslösefall einen Kontakt durch eine Federkraft öffnet. Dabei wird auch im nicht ausgelösten Fall permanent eine mechanische Kraft auf die Verbindungsstelle ausgeübt, was zu Qualitätsproblemen speziell bei langen Einsatzzeiten, wie z.B. den langen Betriebszeiten im Automotiv-Bereich, führen kann. Insbesondere kann nach einiger Zeit eine Zerrüttung der Lötstelle auftreten.

Das Dokument DE 1588425 zeigt eine Thermosicherung gemäße dem Oberbegriff des Anspruchs 1.

Es ist Aufgabe der vorliegenden Erfindung, eine Thermosicherung zur Verfügung zu stellen, die bei unzulässig hohen Umgebungstemperaturen, die z.B. bei von Ausfällen von Bauelementen, Kurzschlüssen bzw. durch Fremdeinwirkung, Fehlfunktionen von Isolationswerkstoffen auftreten, einen Stromfluss sicher unterbricht. Dabei soll die Thermosicherung im Wesentlichen abhängig von der Umgebungstemperatur und nicht von dem Stromfluss durch die Thermosicherung ausgelöst werden, damit auch Störungen, die nur zu Strömen kleiner als die zulässigen Maximalströme führen, sicher erkannt werden können. Weiterhin soll die erfindungsgemäße Thermosicherung eine hohe Zuverlässigkeit insbesondere während einer hohen Lebensdauer aufweisen.

Diese Aufgabe wird durch die Thermosicherung nach Anspruch 1 gelöst.

Weitere vorteilhafte Ausgestaltungen der Erfindung sind in den abhängigen Ansprüchen angegeben.

Gemäß einem Aspekt ist eine Thermosicherung in einer Leitungsstruktur, insbesondere in einem Stanzgitter oder einer Leiterplatte, mit mehreren Leitungsbereichen vorgesehen. Die Leitungsbereiche der Thermosicherung weisen jeweilige Anschlussstellen auf. Ferner ist ein Schmelzelement vorgesehen, das mit den Anschlussstellen der Leitungsstruktur elektrisch und mechanisch verbunden ist, wobei das Material des Schmelzelementes eine Schmelztemperatur aufweist, um bei einer Umgebungstemperatur höher als die Schmelztemperatur aufzuschmelzen, so dass sich Material des Schmelzelementes an den Anschlussstellen sammelt und die durch das Schmelzelement gebildete elektrische Verbindung trennt.

Die obige Thermosicherung kann in einfache Weise durch elektrisches Kontaktieren eines Schmelzelementes zwischen Anschlussstellen eines Stanzgitters aufgebracht werden.

Weiterhin können die Anschlussstellen einen Abstand voneinander aufweisen, bei dem das geschmolzene Material des Schmelzelementes an den Anschlussstellen voneinander elektrisch getrennt ist.

Vorzugsweise wird das Schmelzelement an den Anschlussstellen angelötet, angeschweißt, angeklemmt oder angeklebt.

Weiterhin kann das Schmelzelement mit einem Flussmittel beschichtet sein und/oder in einem Hohlraum im Inneren des Schmelzelementes ein Flussmittel aufweisen. Ein im Inneren des Schmelzelementes eingeschlossenes Flussmittel hat den Vorteil, dass die Alterung des Flussmittels reduziert wird.

Weiterhin können die Anschlussstellen an entsprechenden Kontaktstegen der Leitungsstruktur angeordnet sein, wobei die Kontaktstege ein Federelement aufweisen und/oder wobei mindestens einer der Kontaktstege bezüglich einer durch die Anschlussstellen definierten Richtung eine Krümmung oder Umbiegung aufweist.

Gemäß der Erfindung weist die Leitungsstruktur einen oder mehrere Blindleitungsabschnitte auf, die nicht zur Stromführung beitragen, und/oder einem oder mehrere Querabschnitte aufweisen, die sich quer zu einer durch die Anschlussstellen definierten Anschlussrichtung erstrecken und mit einem Blindleitungsabschnitt oder einem Leitungsabschnitt verbunden sind,

Weiterhin kann das Schmelzelement quaderförmig ausgebildet sein oder einen U-förmigen oder S-förmigen Abschnitt aufweisen, um die Elastizität des Schmelzelementes zu erhöhen, so dass eine Zug oder Stauchungskraft aufgenommen werden kann. Zudem kann dadurch die lokale Verformung verringert werden, um eine Materialermüdung durch wiederholte Verformungen zu verringern.

Gemäß einer Ausführungsform das Schmelzelement aus einem verformbaren Material gebildet ist, wobei die Verformungskraft zum Verformen des Schmelzelementes kleiner ist als eine Mindestkraft, die zu einer Degradation des Schmelzelementes und/oder der Verbindung zwischen der Anschlussstelle und dem Schmelzelement führt.

Weiterhin können die Anschlussstellen in Kontaktelementen vorgesehen sein, die jeweils eine leitende Kontakthülse und eine daran angeschlossene Anschlussleitung aufweisen. Enden des Schmelzelementes sind in die Kontakthülsen eingesetzt und dort jeweils mit Hilfe eines Kontaktmaterials mit der Kontakthülse elektrisch verbunden.

Gemäß einem weiteren Aspekt ist eine Thermosicherung in einer Leitungsstruktur vorgesehen. Die Thermosicherung umfasst ein Kontaktelement, das eine leitende Kontakthülse und eine daran angeschlossene Anschlussleitung aufweist, sowie ein Schmelzelement, in das ein Flussmittel eingebettet ist, wobei ein Ende des Schmelzelementes in die Kontakthülse eingesetzt ist und dort mit Hilfe eines Kontaktmaterials mit der Kontakthülse elektrisch verbunden ist.

Weiterhin kann das Flussmittel als Flussmittelseele in dem Material des Schmelzelementes oder als Zwischenschicht zwischen zwei Schichten des Materials des Schmelzelementes vorgesehen ist.
Weiterhin kann das Kontaktmaterial ein Lotmaterial sein, das eine zu dem Material des Schmelzelementes gleiche Schmelztemperatur oder eine zu dem Material des Schmelzelementes niedrigere Schmelztemperatur aufweist.

Gemäß einem weiteren Aspekt ist ein Verfahren zur Herstellung einer Thermosicherung vorgesehen. Das Verfahren umfasst das Aufschmelzen eines Kontaktmaterials in einer Kontakthülse eines Kontaktelementes durch eine Wärmequelle, das Entfernen der Wärmequelle, und, gleichzeitig mit oder nach dem Entfernen der Wärmequelle, das Einbringen eines Schmelzelementes in die Kontakthülse, wobei das Schmelzelement teilweise aufgeschmolzen wird und sich mit der Kontakthülse über das Kontaktmaterial verbindet.

Bevorzugte Ausführungsformen der Erfindung werden nachfolgend anhand der beigefügten Zeichnungen ausführlich beschrieben. Es zeigen:
Figuren 1a bis 1c eine Thermosicherung in einer Draufsicht, in einer Querschnittsansicht und in einem Auslösezustand;
Figuren 2a und 2b Ausführungsformen zur Ausgestaltung des Schmelzelementes gemäß Ausführungsformen der Erfindung;
Figuren 3a und 3b weitere Ausführungsformen der Erfindung mit verschiedenen Ausgestaltungen des Stanzgitters;
Fig. 4 eine Darstellung einer weiteren Ausführungsform der Thermosicherung gemäß der vorliegenden Erfindung;
Figuren 5a bis 5c eine schematische Darstellung einer Thermosicherung bei einer Verwendung eines Schmelzlegierungselementes aus einem duktilen Material; und
Figuren 6a und 6b weitere Ausführungsformen der Thermosicherung gemäß der vorliegenden Erfindung, bei der eine plastische Verformung des Stanzgitters durch den Schmelzlegierungsblock duktil abgebaut wird; und
Figur 7 eine weitere Ausführungsform der Thermosicherung gemäß der vorliegenden Erfindung.

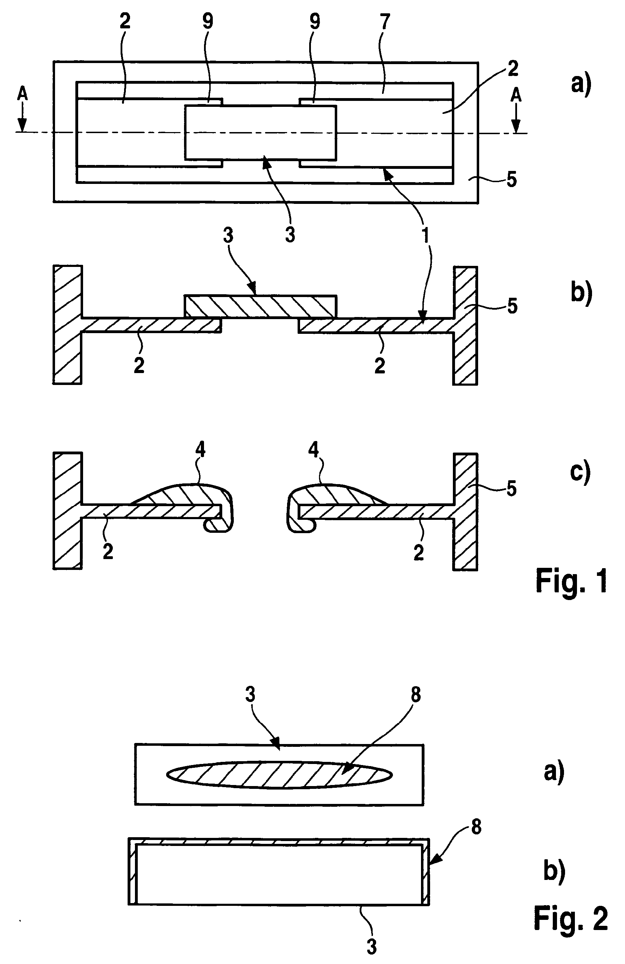

Fig. 1a zeigt eine Draufsicht auf einen Ausschnitt eines Stanzgitters 1 mit einer Leitungsstruktur mit Leitungselementen zum Leiten eines elektrischen Stroms. Derartige Stanzgitter 1 werden im Automobilbereich zum Herstellen von Verbindungselementen eingesetzt, bei denen einzelne elektrische Bauelemente zwischen den Leitungselementen des Stanzgitters 1 aufgebracht werden sollen. Die Leitungsstruktur des Stanzgitters 1 ist von einer Ummantelung 5 aus einem Kunststoffmaterial umgeben, das die einzelnen Leitungselemente fixiert und vor Korrosion schützt. In einer Ausnehmung 7 in der Ummantelung 5 sind zwei Kontaktstege 2 als Teile der Leitungsstruktur nicht von der Ummantelung 5 bedeckt, d.h. im Bereich der beiden Kontaktstege 2 ist die Leitungsstruktur freigelegt.

In Fig. 1b ist das Stanzgitter 1 der Fig. 1a entlang der Schnittlinie A-A dargestellt. Die freiliegenden Kontaktstege 2 werden, wie in Fig. 1b dargestellt ist, über entsprechende Anschlussstellen 9 durch ein leitendes Schmelzelement 3 miteinander elektrisch verbunden, um so eine Thermosicherung in dem Stanzgitter 1 zu bilden. Das Schmelzelement 3 ist bei der gezeigten Ausführungsform quader- bzw. barrenförmig aus einem leicht schmelzenden, elektrisch gut leitenden Metall bzw. einer Metalllegierung oder aus einem Material gefertigt, das Strom gut leitet und einen niedrigen Schmelzpunkt von unter 300°C, unter 250°C bzw. vorzugsweise unter 200°C aufweist. Das Material des Schmelzelementes 3 ist hinsichtlich seines Schmelzpunktes und seiner Leitfähigkeit so gewählt, dass einerseits im normalen Betrieb ein Aufschmelzen des Schmelzelementes 3 bei einer niedrigen Umgebungstemperatur durch einen hohen Stromfluss sicher ausgeschlossen werden kann, und andererseits dieses bei einer hohen Umgebungstemperatur über einer Schwellentemperatur sicher schmilzt.

Das Material des Schmelzelementes 3 ist weiterhin so gewählt, dass es im geschmolzenen Zustand eine Oberflächenspannung aufweist, die nach dem Aufschmelzen in der in Fig. 1b gezeigten Ausführungsform ein Zusammenziehen des Materials des Schmelzelementes 3 auf den Anschlussstellen 9 bewirkt, die zu einer Auftrennung des Strompfades durch das Schmelzelement 3 führt. Fig. 1c zeigt das Material des Schmelzelementes 3, das sich aufgrund seiner Oberflächenspannung an den Anschlussstellen 9 der Kontaktstege 2 tropfenförmig gesammelt hat. Der Abstand zwischen den Enden der zueinander gerichteten Kontaktstege 2 ist dabei so gewählt, dass Tropfen 4 des aufgeschmolzenen Materials des Schmelzelementes 3 im Auslösefall nicht miteinander in Kontakt kommen können.

Bei der Wahl des Materials des Schmelzelementes 3 ist auf eine gute Prozessierbarkeit, Zuverlässigkeit im Normalbetrieb sowie ein sicheres Auslösen im Fehlerfall auch nach längerer Betriebsdauer zu achten. Mögliche Materialien sind z.B. Lote oder sonstige leicht schmelzende (bei niedrigen Temperaturen zwischen 100°C und 300°C schmelzende) Materialien.

Als mögliches Material kommt z.B. SnSb- oder SnPb-Lot in Betracht, das jedoch einer erheblichen Alterung unterliegt. In diesem Fall kann, wie in den Figuren 2a und 2b gezeigt ist, das Schmelzelement 3 mit einem Flussmittel 8 versehen sein, dass innerhalb des Schmelzelementes 3 (Fig. 2a) oder als Schicht außerhalb des Schmelzelementes 3 (siehe Fig. 2b) z.B. durch Eintauchen vorgesehen ist. Im Fall der Fig. 2a kann durch das Einschließen des Flussmittels z.B. in einem Hohlraum in dem Schmelzelement 3 eine Alterung des Flussmittels reduziert werden. Auch ist eine Aufnahme des Flussmittels zwischen zwei Schichten des Materials des Schmelzelementes 3 alternativ möglich.

Alternativ kann als Material für das Schmelzelement ein alterungsresistenteres Material, z.B. SnAgCu-Lot, verwendet werden. Ein Flussmittel zur Verbesserung der Oberflächenspannung wird auch bei diesem Material benötigt.

Bei einem Aufschmelzen zieht sich das Schmelzelement 3 je nach Benetzbarkeit der Kontaktstege 2 bzw. der Anschlussstellen 9 zu zwei kugelähnlichen Strukturen zusammen oder benetzt den Kontaktsteg 2 schichtartig. Um eine Oxidation des Schmelzelements 3 zu vermeiden, können dessen Oberflächen teilweise oder ganz beschichtet sein, wie z.B. mit Gold oder Kupfer.

Beim Befestigen des Schmelzelementes 3 ist zum einen auf eine gute elektrische Leitfähigkeit zu achten und zum anderen darauf, dass das Schmelzelement 3 zuverlässig an den Leitungsbereichen 2 gehalten wird. Mögliche Verbindungstechniken sind z.B. das Löten mit einem Lot, dessen Schmelztemperatur niedriger liegt als die des Schmelzelementes. Das Löten kann z.B. mithilfe eines Lasers oder sonstigen bekannten Lötverfahren durchgeführt werden, wobei auch das direkte Auflöten des Schmelzelementes durch lokales Aufschmelzen möglich ist, so dass das Aufbringen eines Lotmaterials, z.B. in Form einer Lotpaste, u.U. verzichtbar ist. Das lokale Aufschmelzen kann beispielsweise durch Durchleiten von Strompulsen, durch Laserheizen, Induktion, Wärmeleitung, Heißluft oder Wärmestrahlung durchgeführt werden.

Eine weitere Möglichkeit, das Schmelzelement 3 mit den Kontaktstegen 2 zu verbinden, besteht darin, dieses durch Kleben mit einem leitfähigen Kleber durchzuführen. Dies ist insbesondere vorteilhaft, wenn das Schmelzelement 3 mit einer Haftschicht und/oder Oxidationsschicht versehen ist, die ein Löten erschwert. Zusätzlich zum Kleben, kann ein Bondingprozess durchgeführt werden, bei ein Bonddraht zwischen dem Schmelzelement 3 und dem entsprechenden Kontaktsteg 2 angeschlossen wird, um das Schmelzelement 3 in zuverlässiger Weise elektrisch mit den Kontaktstegen 2 des Stanzgitters 1 zu verbinden.

Weitere Möglichkeiten bestehen im Verbinden des Schmelzelementes 3 mit den Kontaktstegen 2 durch Reibschweißen, Diffusions- und Ultraschallschweißen, Laserschweißen und dgl. Alternativ kann das Schmelzelement 3 auch durch mechanisches klemmen, z.B. durch Crimpen oder durch Schneidklemmen, mit den Leitungsbereichen 2 des Stanzgitters 1 verbunden werden.

Bei der Anordnung des Schmelzelementes 3 auf dem Stanzgitter 1 ist darauf zu achten, dass mechanische Spannungen durch eine nachfolgende Prozessierung, die eine bei Temperaturschwankung hervorruft, wie z.B. ein Umspritzen des Stanzgitters 1 mit einem Kunststoffmaterial, um eine Ummantelung herzustellen, und während des Betriebs gering bleiben. Mechanische Spannungen können zu einer Degradation des Schmelzsicherungselement oder zu einer Zerrüttung bzw. Degradation der Verbindung zwischen dem Schmelzsicherungselement 3 und den Kontaktstegen 2 (z.B. die Lötstelle) führen.

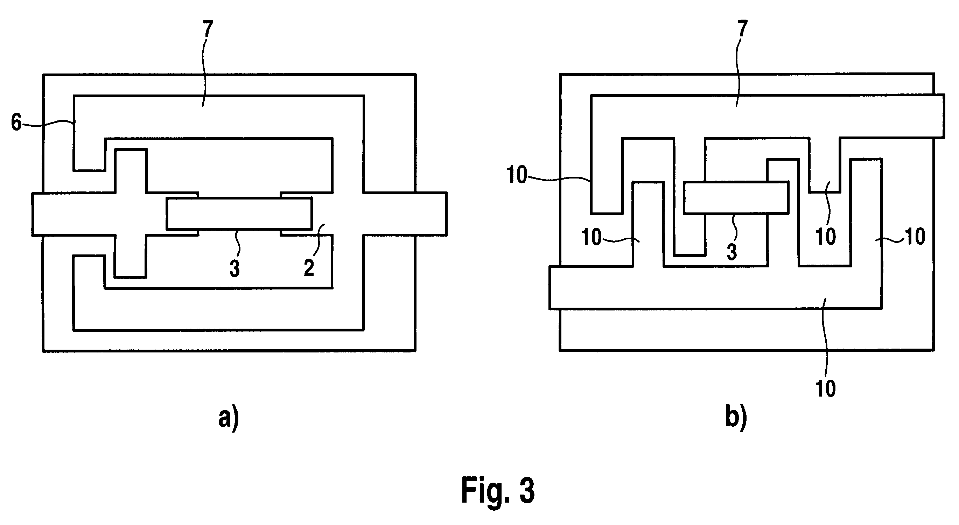

Um eine übergroße Belastung des Schmelzsicherungselements 3 aufgrund von mechanischen Spannungen der Leiterbahnen im Stanzgitter 1 zu vermeiden und dadurch die Zuverlässigkeit der Thermosicherung zu erhöhen, kann, wie in den Figuren 3a und 3b gezeigt ist, das Stanzgitter 1 zusätzlich die Leitungsstrukturen des Stanzgitters 1 Entlastungsstrukturen aufweisen, die eine bessere Fixierung in der Ummantelung 5 gewährleisten. Darüber hinaus kann vorgesehen sein, dass die Entlastungsstrukturen des Stanzgitters 1 ineinander greifen und/oder den von mechanischen Spannungen zu entlastenden Bereich ganz oder teilweise umschließen, so dass mechanische Spannungen von den Entlastungsstrukturen an die Ummantelung 5 abgegeben werden. Umgekehrt können auch von der Ummantelung ausgehende mechanische Spannungen von den Entlastungsstrukturen aufgenommen werden.

Wie in Fig. 3a dargestellt ist, wird das Ineinandergreifen der Entlastungsstrukturen durch das Vorsehen von mit den Leiterbahnen verbundenen Blindleitungsabschnitten 6 realisiert, die in der Ummantelung 5 eingebettete Abschnitte darstellen, die quer zu einer Anschlussrichtung des Schmelzsicherungselementes 3, d.h. quer zur Richtung der Stromführung zwischen den beiden Anschlussstellen 9 des Schmelzelementes 3 angeordnet sind. Die Anschlussrichtung des Schmelzelementes 3 wird durch die Richtung der Anschlussstellen 9 definiert, an denen das Schmelzelement 3 an den Kontaktstegen 2 angeschlossen ist.

Einer oder beide der Leiterbahnen, die zu den entsprechenden Kontaktstegen 2 führen, weisen darüber hinaus einen Leitungsarmabschnitt auf, der seitlich an den Kontaktstegen 2 und dem Schmelzelement 3 vorbei geführt ist und mit dem entsprechenden Blindleitungsabschnitt 6 versehen ist, der von dem Leitungsarmabschnitt quer in Richtung zu der jeweils anderen Leiterbahn absteht, ohne diese zu kontaktieren. So werden das Schmelzelement 3 und die dazugehörigen Kontaktstege 2 zumindest teilweise von dem Leitungsarmabschnitt und dem Blindleitungsabschnitt 6 umschlossen, so dass mechanische Spannungen in der Kunststoffummantelung, in der sowohl Leitungsarmabschnitt als auch der Blindleitungsabschnitt 6 eingebettet sind, aufgenommen werden können.

In Fig. 3b ist eine weitere Ausführungsform dargestellt, wobei die Leiterbahnen, die mit den entsprechenden Kontakten des Schmelzelementes 3 verbunden sind, jeweils Querabschnitte 10 aufweisen, die bezüglich der Anschlussrichtung des Schmelzelementes 3 ineinander greifen, d.h. abwechselnd von einer der Leiterbahnen und einer anderen der Leiterbahnen ausgehen. Zwei benachbarte der Querabschnitte 10 bilden dabei die Kontaktstege 2 zum Anschließen des Schmelzelementes 3. Die Querabschnitte 10 können so gewählt sein, dass die Richtung des Stromflusses in dem Schmelzelement 3 zu der Richtung des Stromflusses in den benachbarten Leitungselementen 2 entgegengesetzt verläuft.

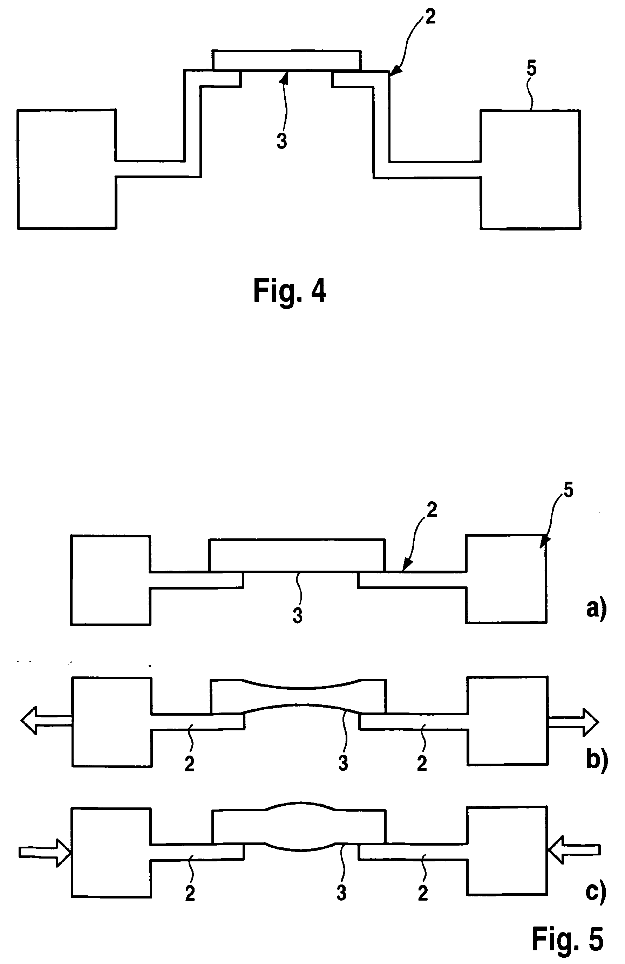

Eine weitere Möglichkeit, eine Krafteinwirkung auf das Schmelzelement 3 und auf die 9 stellen mit den Kontaktstegen 2, insbesondere eine Zugkraft oder Stauchung zu vermeiden, besteht darin, die Leiterbahnen des Stanzgitters 1 mit einem zusätzlichen Federelement oder einer entsprechenden Form, wie sie in Fig. 4 gezeigt ist, zu versehen, die geeignet ist, eine in Richtung des Schmelzsicherungselements 3 wirkende Kraft aufzufangen. Es kann beispielsweise vorgesehen sein, dass einer oder mehrere der der Kontaktstege 2 eine Biegung oder eine Abwinkelung aufweisen, um eine erhöhte Elastizität in Zugrichtung und Stauchungsrichtung zu schaffen. Dadurch können sich die entsprechenden Kontaktstege 2 bei Einwirken einer Kraft aufgrund ihrer erhöhten Elastizität leicht verbiegen, ohne die elektrische Verbindung zu unterbrechen und dadurch die Belastung des Schmelzsicherungselementes 3 oder dessen Kontaktierung vermindern.

Weiterhin kann, wie in den Figuren 5a bis 5c dargestellt ist, als Material für das Schmelzelement 3 ein duktiles Material vorgesehen sein, das sich auf eine Zugbelastung (siehe Fig. 5b) bzw. eine Stauchungsbelastung (siehe Fig. 5c) entsprechend verformt, und dadurch die Belastung der Anschlussstellen 9 zwischen dem Schmelzelement 3 und den Kontaktstegen 2 reduziert.

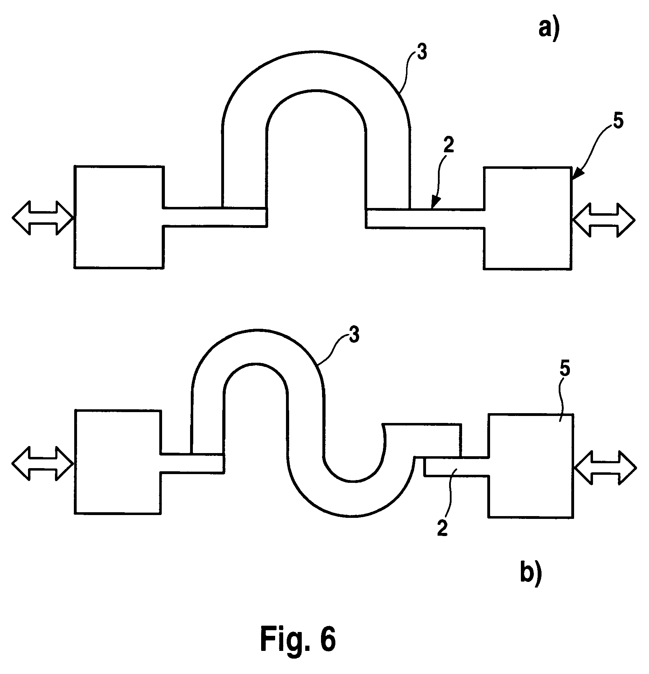

Während in den vorangehenden Ausführungsformen das Schmelzelement 3 barrenförmig vorgesehen ist, ist es gemäß weiterer Ausführungsformen, die in den Figuren 6a und 6b gezeigt sind, möglich, das Schmelzelement 3 auch U-förmig oder S-förmig zwischen den Anschlussstellen 9 der Kontaktstege 2 vorzusehen, sodass eine mechanische Last sowohl in horizontaler als auch in vertikaler Richtung duktil (leicht verformbar) durch das Schmelzelement 3 aufgenommen werden kann, ohne ein besonders duktiles Material wie bei der Ausführungsform der Fig. 4 vorsehen zu müssen. Dadurch wirkt eine Kraft in Anschlussrichtung des Schmelzelementes 3 nicht direkt auf die Anschlussstellen 9, wodurch deren Zuverlässigkeit und Langzeitstabilität erheblich vergrößert wird. Darüber hinaus wird die Verformung des Schmelzelementes 3 bei entsprechend relativer Bewegung zwischen den Anschlussstellen 9 verteilt, so dass eine Materialermüdung verringert wird.

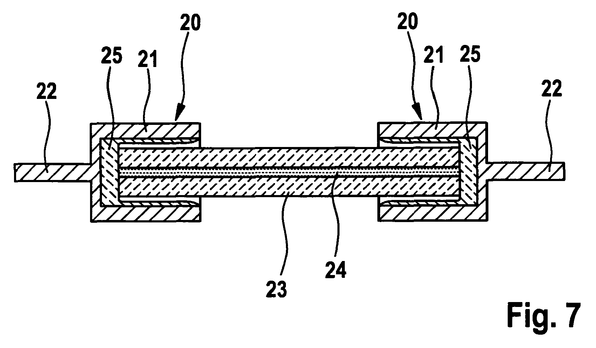

Fig. 7 zeigt eine weitere Ausführungsform, bei der anstelle eines Stanzgitters als Leitungsstruktur zwei Kontaktelemente 20 vorgesehen sind. Die beiden Kontaktelemente 20 sind jeweils mit einer einseitig offene Kontakthülse 21 ausgebildet, die mit einem Anschlussdraht 22 als Anschlussleitung zur Kontaktierung der Thermosicherung versehen sind. Die Kontaktelemente 20 sind leitend ausgebildet und vorzugsweise aus einem metallischen Material gefertigt.

In ein offenes Ende der Kontakthülse 21 ist jeweils ein Ende eines Schmelzelementes 23 aufgenommen, deren Funktionsweise den Schmelzelementen, die in den vorherigen Ausführungsformen beschrieben sind, entspricht. Das Schmelzelement 23 kann eines der zuvor genannten Materialien für Schmelzelemente aufweisen. In der gezeigten Ausführungsform ist das Schmelzelement 23 aus einem Lotmaterial gebildet, in dem eine Seele aus Flussmittel 24 eingeschlossen ist, die sich zwischen den enden des Schmelzelementes 23 erstreckt. Alternativ kann das Flussmittel auch als Zwischenschicht zwischen zwei Schichten des Materials des Schmelzelementes 23 angeordnet sein, die sich zwischen den Enden des Schmelzelementes erstreckt. Im erstgenannten Fall kann das Schmelzelement 23 vorzugsweise einen runden Querschnitt aufweisen und in ebenfalls zylinderförmige Kontakthülsen 21 eingeschoben sein.

Die Verbindung zwischen den Kontakthülsen 21 und den entsprechenden Enden des Schmelzelementes 23 kann durch ein Kontaktierungslot 25 erfolgen, das bei niedrigerer Temperatur als der Schmelztemperatur des Materials des Schmelzelementes schmilzt. Die Montage einer derartigen Thermosicherung kann also durchgeführt werden, indem eine Lotpaste aus dem Kontaktierungslot 25 in die Kontakthülse 21 eingebracht wird und anschließend das entsprechende Ende des Schmelzelementes 23 in die Hülse geschoben wird, sodass es die Lotpaste zwischen dem verschlossenen Ende der Kontakthülse 21 und dem Ende des Schmelzelementes 23 einschließt. Durch einen Temperaturschritt (Wärmezufuhr) wird nun die Lotpaste aufgeschmolzen, wobei die Temperatur jedoch so gewählt ist, dass sie das Material des Schmelzelementes 23 nicht zum Schmelzen bringt. Die Kontakthülsen 21 können anstelle eines zylinderförmigen Querschnittes auch rechteckige oder sonstige Querschnitte aufweisen, die geeignet sind, entsprechend geformte Schmelzelemente 23 aufzunehmen.

Auf diese Weise wird eine Thermosicherung gebildet, die aufgrund der Anschlussdrähte 22 and den Kontakthülsen 21 wie ein herkömmliches elektrisches bzw. elektronisches Bauelement in elektronischen Schaltungen verbaut werden kann.

Alternativ kann als Material für die Lotpaste 25 auch das gleiche Material wie dasjenige der Schmelzsicherung verwendet werden. In diesem Fall erfolgt die Montage, indem zunächst die Lotpaste in die entsprechenden Kontakthülsen 21 eingebracht wird und diese so weit erwärmt wird, bis das Material der Lotpaste schmilzt. Anschließend werden die entsprechenden Enden des Schmelzelementes 23 in die Hülse hinein geschoben, bis sie in Kontakt mit der Lotpaste kommen und gleichzeitig oder kurz zuvor wird die Wärmequelle zum Aufschmelzen der Lotpaste 25 entfernt, sodass das Schmelzelement 23 lediglich aufgrund der Restwärme an seinen Enden kurz aufgeschmolzen wird und dann aufgrund des schnellen Absinkens der Temperatur der aufgeschmolzenen Lotpaste 25 fest mit der Kontakthülse 21 über die sich verfestigende Lotpaste 25 verbunden wird. Auf diese Weise ist es möglich, ein solches Schmelzelement 23 nur unter Verwendung eines einzigen Lotmaterials herzustellen.

## Patentansprüche

1. Thermosicherung in einer Leitungsstruktur, insbesondere in einem Stanzgitter,
mit mehreren Leitungsbereichen (2) mit jeweiligen Anschlussstellen (9); und
mit einem Schmelzelement (3), das mit den Anschlussstellen (9) der Leitungsstruktur elektrisch und mechanisch verbunden ist, wobei das Material des Schmelzelementes (3) eine Schmelztemperatur aufweist, um bei einer Umgebungstemperatur über der die Schmelztemperatur aufzuschmelzen, so dass sich Material des Schmelzelementes (3) an den Anschlussstellen (9) aufgrund einer Oberflächenspannung sammelt und die durch das Schmelzelement (3) gebildete elektrische Verbindung trennt, **dadurch gekennzeichnet, dass**
die Leitungsstruktur in einer Ummantelung eingebettet ist, und
dass die Leitungsstruktur einen oder mehrere Blindleitungsabschnitte (6), die nicht zur Stromführung beitragen, und/oder einen oder mehrere Querabschnitte (10) aufweist, die sich quer zu einer durch die Anschlussstellen (9) definierten Anschlussrichtung erstrecken und mit einem Blindleitungsabschnitt (6) oder einem Leitungsabschnitt verbunden sind.

2. Thermosicherung nach Anspruch 1, wobei die Anschlussstellen (9) einen Abstand voneinander aufweisen, bei dem das geschmolzene Material des Schmelzelementes (3) an den Anschlussstellen (9) voneinander elektrisch getrennt ist.

3. Thermosicherung nach Anspruch 1 oder 2, wobei das Schmelzelement (3) an den Anschlussstellen (9) angelötet, angeschweißt, angeklemmt oder angeklebt ist.

4. Thermosicherung nach einem der Ansprüche 1 bis 3, wobei das
Schmelzelement (3) mit einem Flussmittel (8) beschichtet ist und/oder eine Flussmittelseele in dem Material des Schmelzelementes oder eine Zwischenschicht zwischen zwei Schichten des Materials des Schmelzelementes vorgesehen ist.

5. Thermosicherung nach einem der Ansprüche 1 bis 4, wobei die Anschlussstellen (9) an entsprechenden Kontaktstegen (2) der Leitungsstruktur angeordnet sind, wobei die Kontaktstege (2) ein Federelement aufweisen und/oder wobei mindestens einer der Kontaktstege (2) bezüglich einer durch die Anschlussstellen (9) definierten Richtung eine Krümmung oder Umbiegung aufweist.

6. Thermosicherung nach Anspruch 1, wobei das Schmelzelement (3) quaderförmig ausgebildet ist oder einen U-förmigen oder S-förmigen Abschnitt aufweist.

7. Thermosicherung nach einem der Ansprüche 1 bis 6, wobei das Schmelzelement (3) aus einem verformbaren Material gebildet ist, wobei die Verformungskraft zum Verformen des Schmelzelementes (3) kleiner ist als eine Mindestkraft, die zu einer Degradation des Schmelzelementes und/oder der Verbindung zwischen der Anschlussstelle (9) und dem Schmelzelement (3) führt.

8. Thermosicherung nach einem der Ansprüche 1 bis 7, wobei die Anschlussstellen in Kontaktelementen (20) vorgesehen sind, die jeweils eine leitende Kontakthülse (21) und eine daran angeschlossene Anschlussleitung (22) aufweisen; und
wobei Enden des Schmelzelementes in die Kontakthülsen (21) eingesetzt sind und dort jeweils mit Hilfe eines Kontaktmaterials (25) mit der Kontakthülse (21) elektrisch verbunden sind.

## Claims

1. Thermal fuse in a conducting structure, in particular in a leadframe,
with a plurality of conducting areas (2) with respective connection points (9); and
with a fusible element (3), which is electrically and mechanically connected to the connection points (9) of the conducting structure, the material of the fusible element (3) having a melting point in order to melt at an ambient temperature greater than the melting point, such that material of the fusible element (3) collects at the connection points (9) as a result of surface tension and the electrical connection formed by the fusible element (3) breaks,
**characterized in that**
the conducting structure is embedded in an enclosure, and
**in that** the conducting structure has one or more stub portions (6), which do not contribute to carrying current, and/or has one or more cross portions (10), which extend transversely to a connecting direction defined by the connection points (9) and are connected to a stub portion (6) or a conducting portion.

2. Thermal fuse according to Claim 1, the connection points (9) being at a distance from one another at which the molten material of the fusible element (3) is electrically separated at the connection points (9).

3. Thermal fuse according to Claim 1 or 2, the fusible element (3) being soldered, welded, clamped or glued on at the connection points (9).

4. Thermal fuse according to one of Claims 1 to 3, the fusible element (3) being coated with a flux (8) and/or a flux core being provided in the material of the fusible element or an intermediate layer being provided between two layers of the material of the fusible element.

5. Thermal fuse according to one of Claims 1 to 4, the connection points (9) being arranged at corresponding contact webs (2) of the conducting structure, the contact webs (2) having a spring element and/or at least one of the contact webs (2) having a curvature or bend with respect to a direction defined by the connection points (9).

6. Thermal fuse according to Claim 1, the fusible element (3) being of a cuboidal form or having a U-shaped or S-shaped portion.

7. Thermal fuse according to one of Claims 1 to 6, the fusible element (3) being formed from a deformable material, the deformation force for deforming the fusible element (3) being less than a minimum force that leads to a degradation of the fusible element and/or of the connection between the connection point (9) and the fusible element (3).

8. Thermal fuse according to one of Claims 1 to 7, the connection points being provided in contact elements (20) that respectively have a conducting contact sleeve (21) and a connection line (22) connected thereto; and
ends of the fusible element being inserted in the contact sleeves (21) and electrically connected there to the contact sleeve (21), in each case with the aid of a contact material (25).

## Revendications

1. Fusible thermique dans une structure de lignes, en particulier dans un grillage estampé,
avec plusieurs zones de lignes (2) avec des points de raccordement respectifs (9); et
avec un élément fusible (3), qui est électriquement et mécaniquement raccordé aux points de raccordement (9) de la structure de lignes, dans lequel le matériau de l'élément fusible (3) présente une température de fusion afin de fondre à une température ambiante supérieure à la température de fusion, de telle manière que du matériau de l'élément fusible (3) s'accumule aux points de raccordement (9) en raison de la tension superficielle et sépare la liaison électrique formée par l'élément fusible (3),
**caractérisé en ce que** la structure de lignes est logée dans une enveloppe, et **en ce que** la structure de lignes présente une ou plusieurs parties de ligne aveugles (6), qui ne contribuent pas au transport du courant, et/ou une ou plusieurs parties transversales (10), qui s'étendent transversalement à une direction de raccordement définie par les points de raccordement (9) et qui sont reliées avec une partie de ligne aveugle (6) ou une partie de ligne.

2. Fusible thermique selon la revendication 1, dans lequel les points de raccordement (9) présentent une distance l'un de l'autre, pour laquelle le matériau fondu de l'élément fusible (3) aux points de raccordement (9) est électriquement séparé l'un de l'autre.

3. Fusible thermique selon la revendication 1 ou 2, dans lequel l'élément fusible (3) est brasé, soudé, serré ou collé aux points de raccordement (9).

4. Fusible thermique selon l'une quelconque des revendications 1 à 3, dans lequel l'élément fusible (3) est revêtu d'un fondant (8) et/ou il est prévu une âme de fondant dans le matériau de l'élément fusible ou une couche intermédiaire entre deux couches du matériau de l'élément fusible.

5. Fusible thermique selon l'une quelconque des revendications 1 à 4, dans lequel les points de raccordement (9) sont disposés sur des nervures de contact correspondantes (2) de la structure de lignes, dans lequel les nervures de contact (2) présentent un élément de ressort et/ou dans lequel au moins une des nervures de contact (2) présente une courbure ou une inflexion par rapport à une direction définie par les points de raccordement (9).

6. Fusible thermique selon la revendication 1, dans lequel l'élément fusible (3) est de forme parallélépipédique ou présente une partie en forme de U ou en forme de S.

7. Fusible thermique selon l'une quelconque des revendications 1 à 6, dans lequel l'élément fusible (3) est formé d'un matériau déformable, dans lequel la force de déformation pour déformer l'élément fusible (3) est inférieure à une force minimale, qui conduit à une dégradation de l'élément fusible et/ou de la liaison entre les points de raccordement (9) et l'élément fusible (3).

8. Fusible thermique selon l'une quelconque des revendications 1 à 7, dans lequel les points de raccordement sont prévus dans des éléments de contact (20), qui présentent respectivement une douille de contact conductrice (21) et une ligne de raccordement (22) raccordée à celle-ci; et dans lequel des extrémités de l'élément fusible sont introduites dans les douilles de contact (21) et y sont respectivement raccordées électriquement à la douille de contact (21) à l'aide d'un matériau de contact (25).
